(19) **Europäisches Patentamt / European Patent Office / Office européen des brevets**

(11) **EP 4 322 282 B1**

(12) **EUROPEAN PATENT SPECIFICATION**

(45) Date of publication and mention
of the grant of the patent:
**29.07.2026 Bulletin 2026/31**

(21) Application number: **22819171.4**

(22) Date of filing: **29.03.2022**

(51) International Patent Classification (IPC):
*H01M 10/48* (2006.01)   *H01M 10/42* (2006.01)
*H01M 10/0585* (2010.01)   *H01M 10/052* (2010.01)
*H01M 10/0525* (2010.01)   *H01M 10/0587* (2010.01)

(52) Cooperative Patent Classification (CPC):
**H01M 10/0587; H01M 10/052; H01M 10/0525;
H01M 10/0585; H01M 10/4235; H01M 10/48;**
H01M 2220/20; H01M 2220/30; Y02E 60/10;
Y02P 70/50

(86) International application number:
**PCT/CN2022/083838**

(87) International publication number:
**WO 2022/257566 (15.12.2022 Gazette 2022/50)**

(54) **THREE-ELECTRODE CELL STRUCTURE AND PREPARATION METHOD THEREFOR, AND METHOD FOR TESTING NEGATIVE ELECTRODE POTENTIAL**

DREIELEKTRODEN-ZELLSTRUKTUR UND HERSTELLUNGSVERFAHREN DAFÜR SOWIE VERFAHREN ZUM TESTEN DES NEGATIVEN ELEKTRODENPOTENZIALS

STRUCTURE CELLULAIRE À TROIS ÉLECTRODES ET SON PROCÉDÉ DE PRÉPARATION, ET PROCÉDÉ DE TEST DE POTENTIEL D'ÉLECTRODE NÉGATIVE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **09.06.2021 CN 202110640079**

(43) Date of publication of application:
**14.02.2024 Bulletin 2024/07**

(73) Proprietor: **SVOLT Energy Technology Co., Ltd.
Changzhou, Jiangsu 213200 (CN)**

(72) Inventors:
• **LI, Shuxian
  Hangzhou, Jiangsu 213200 (CN)**
• **DU, Jianping
  Hangzhou, Jiangsu 213200 (CN)**
• **ZHANG, Yaojun
  Hangzhou, Jiangsu 213200 (CN)**
• **LIU, Ziqi
  Hangzhou, Jiangsu 213200 (CN)**
• **YU, Ao
  Hangzhou, Jiangsu 213200 (CN)**
• **DUAN, Ruijie
  Hangzhou, Jiangsu 213200 (CN)**
• **YANG, Hongxin
  Hangzhou, Jiangsu 213200 (CN)**
• **GAO, Fei
  Hangzhou, Jiangsu 213200 (CN)**
• **LUO, Zhaojun
  Hangzhou, Jiangsu 213200 (CN)**

(74) Representative: **Michalski Hüttermann & Partner mbB
Kaistraße 16A
40221 Düsseldorf (DE)**

(56) References cited:
WO-A1-2017/156757   CN-A- 107 293 778
CN-A- 107 677 712   CN-A- 108 519 410
CN-A- 108 987 659   CN-A- 110 797 569
CN-A- 110 797 569   CN-A- 113 258 156
JP-A- 2010 040 406   US-A1- 2008 073 217

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 322 282 B1

## Description

### TECHNICAL FIELD

The present invention relates to the field of batteries, in particular to a three-electrode cell structure and a preparation method therefor, and a method for testing an electric potential of a negative electrode.

### BACKGROUND

Lithium batteries, as a power source for electronic products, are widely used and essential in social life. The increasing consumption of fossil energy on Earth and the resulted environmental issues have also sounded an alarm for human energy applications. On the one hand, it is necessary to develop and utilize renewable energy to reduce dependence on single fossil energy, and on the other hand, it is necessary to control and harmlessly treat harmful substances generated by the consumption of the fossil energy. In response to these issues, replacing existing fossil energy with electric energy for driving vehicles, namely developing power battery vehicles, has become one of the efforts of various countries.

WO 2017/156757 discloses lithium-ion batteries assembled using a plurality of electrically interconnected battery pouches to obtain the electrical potential and power requirements of the battery application. Such battery pouches may be prepared to contain a stacked grouping, or a wound grouping, of inter-layered and interconnected anodes, cathodes, and separators, each wetted with a liquid electrolyte. A reference electrode, an optional auxiliary reference electrode, and adjacent enclosing modified working electrodes are combined in a specific arrangement and inserted within the stack structure, or the wound structure, of other cell members to enable accurate assessment of both anode group and cathode group performance, and to validate and regenerate reference electrode capability.

CN110797569 A relates to the technical field of secondary batteries, in particular to a four-electrode lithium ion battery and a method for measuring its potential.

However, during the use of lithium batteries, a lithium precipitation phenomenon is prone to occurring in negative electrodes, the generation of lithium precipitation will accelerate the capacity degradation of the batteries, in severe cases, it will puncture separator membranes, causing internal short circuits, and resulting in serious safety accidents. Therefore, how to accurately judge whether lithium precipitation occurs in lithium battery cells is very important.

At present, methods for judging lithium precipitation of the cells include: 1, a three-electrode method, taking an electric potential of a negative electrode of 0 V as a standard for negative electrode lithium precipitation; 2, a voltage relaxation curve method, taking whether there is a characteristic peak in a voltage curve in a standing state after charging as a judging standard for lithium precipitation; 3, a discharge capacity differential curve method, judging whether lithium precipitation occurs by observing whether there is a characteristic peak in a capacity differential curve in a discharging process; and 4, a visual method, mainly, disassembling the cells in a cycling process in a fully charged state, observing a negative electrode interface and judging whether lithium precipitation occurs.

However, in the current testing methods, the voltage relaxation curve and discharge capacity differential curve methods have obvious characteristic peaks when lithium precipitation occurs at a low temperature in the cells, but the characteristic peaks are difficult to observe at a room temperature, such that there are certain limitations. The visual method requires a long-time cycling test to judge whether lithium precipitation occurs through cycling disassembly, the time consumption is long, and costs are high. Moreover, the method for judging whether lithium precipitation occurs by disassembling a battery to observe a negative electrode interface is affected by human influence greatly due to the limitations of human visual observation, which will result in errors in the judgment of results and cannot be quantified through specific data. A relatively mature method is to judge whether lithium precipitation occurs through a three-electrode cell, with the electric potential of the negative electrode of 0 V as a standard. When the electric potential of the negative electrode is less than 0 V, it is considered that lithium precipitation occurs. However, in an actual production process of the three-electrode cell, it is necessary to add a separator membrane outside a reference electrode, the separator membrane is introduced into the production process to generate polarization, which will cause a certain deviation in test results of three electrodes, and correction is required.

In summary, in the prior art, when the three-electrode method is used to test the electric potential of the negative electrode, there is a deviation due to the introduction of the separator membrane, which results in inaccurate test results. Therefore, it is necessary to provide a testing method that can eliminate the polarization generated by the introduction of the separator membrane in a three electrode production process to a maximum extent, so that the deviation is effectively removed, and real potential on a surface of a negative electrode is obtained.

### SUMMARY OF THE INVENTION

A main objective of the present invention is to provide a method for testing an electric potential of a negative electrode, as defined in the appending claims, so as to solve the problem of inaccurate test results caused by polarization generated by the introduction of a separator membrane when using a three-electrode method to test the electric potential of the negative electrode in the prior art.

In an example not according to the present invention a three-electrode cell structure is provided, including a shell, an electrolyte solution encapsulated inside the shell, and at least one electrode group, the electrode group includes a positive electrode, a negative electrode and a first separator membrane located between the positive electrode and the negative electrode, and the at least one electrode group further includes a first reference electrode, located between the negative electrode and the first separator membrane; a second separator membrane, located between the negative electrode and the first reference electrode; a second reference electrode, located between the positive electrode and the first separator membrane; and a third separator membrane, located between the positive electrode and the second reference electrode. The first separator membrane, the second separator membrane and the third separator membrane all have the same structure.

Further, the first reference electrode and the second reference electrode are both copper wires; preferably, each of the copper wires has a first end head and a second end head opposite to the first end head, wherein the first end head is a bare copper wire end head and located between the positive electrode and the negative electrode; and the second end head is an enamelled copper wire end head and located outside the space between the positive electrode and the negative electrode, and the second end head penetrates through the shell to extend to the outside of the shell.

Further, the first end head has a length ranging from 1 cm to 2.5 cm; and preferably, the enamelled copper wire end head has a diameter ranging from 22 $\mu$m to 53 $\mu$m, and the bare copper wire end head has a diameter ranging from 20 $\mu$m to 50 $\mu$m.

Further, a metal lithium layer is plated on a surface of the first end head.

Further, when the three-electrode cell structure includes a plurality of electrode groups, the plurality of electrode groups are sequentially connected in parallel, every two adjacent electrode groups are separated by a fourth separator membrane, and the fourth separator membrane has the same structure as the first separator membrane.

Additionally, an example that is not according to the invention discloses a preparation method for the above three-electrode cell structure is provided, including the following steps: step S1, providing at least one electrode group, wherein each electrode group includes a positive electrode, a negative electrode and a first separator membrane located between the positive electrode and the negative electrode, and the at least one electrode group further includes a first reference electrode disposed between the negative electrode and the first separator membrane; a second separator membrane disposed between the negative electrode and the first reference electrode; a second reference electrode disposed between the positive electrode and the first separator membrane; and a third separator membrane disposed between the positive electrode and the second reference electrode, wherein the first separator membrane, the second separator membrane and the third separator membrane all have the same structure; and step S2, encapsulating the at least one electrode group by a shell, and filling the shell with an electrolyte solution to obtain the three-electrode cell structure.

Further, in step S1, a process of disposing the first reference electrode and the second reference electrode is as follows: putting one end of an enamelled copper wire into concentrated sulfuric acid to remove an enamelled coating on a surface, then washing with water to obtain a copper wire with a first end head as a bare copper wire end head and a second end head as an enamelled copper wire end head; putting the first end head of one copper wire prepared by the above step between the negative electrode and the first separator membrane, and putting the second end head thereof outside the space between the negative electrode and the first separator membrane to form the first reference electrode; putting the first end head of another copper wire prepared by the above step between the positive electrode and the first separator membrane, and putting the second end head thereof outside the space between the positive electrode and the first separator membrane to form the second reference electrode; and arranging, after encapsulation, the second end heads of the first reference electrode and the second reference electrode to both penetrate through the shell to extend to the outside of the shell.

Further, after the step of filling the shell with the electrolyte solution, the step S2 further includes a step of plating lithium on a surface of the bare copper wire end head; preferably, lithium plating treatment is performed on the surfaces of the bare copper wire end heads of the first reference electrode and the second reference electrode respectively at a current ranging from 10 mA to 15 mA by using an external power supply; and preferably, a lithium plating treatment process is performed for treatment time ranging from 6h to 8h.

According to the present invention, a method for testing an electric potential of a negative electrode according to claim 1 is provided. The method includes the following steps:
providing a three-electrode cell described in the example not according to the invention, above the three-electrode cell being of the above three-electrode cell structure or a three-electrode cell structure prepared by the above preparation method, wherein a negative electrode in the three-electrode cell is a to-be-tested negative electrode; charging the three-electrode cell, and in the charging process, recording an electric potential change of a first reference electrode relative to the negative electrode as $\varphi1$, recording an electric potential change of a second reference electrode relative to the negative a electrode as $\varphi2$, designating a potential value of the negative electrode as $\varphi_{negative\ electrode}$, and designating a polarization value caused by a separator membrane as $\Delta\varphi_{\text{separator membrane}}$; and calculating the potential value of the negative electrode by using the following formula I and formula II: $\Delta\varphi_{\text{separator membrane}}=\varphi 2-\varphi 1$, and $\varphi_{\text{negative electrode}}=\varphi 1-\Delta\varphi_{\text{separator membrane}}$.

Further, the charging process is performed at a temperature ranging from -45°C to 60°C.

In the three-electrode cell structure of the present invention, the second separator membrane, the first reference electrode, the first separator membrane, the second reference electrode and the third separator membrane are sequentially disposed between the negative electrode and the positive electrode of the at least one electrode group in a stacked mode. In an actual measurement process, assembly is performed according to the three-electrode cell structure provided in the present invention in a production process of laminating and winding cells; then, polarization generated by the introduction of the separator membrane in testing the three electrodes can be corrected by testing a potential difference between the negative electrode and the first reference electrode, and a potential difference between the negative electrode and the second reference electrode, so that a deviation is effectively removed; and a more accurate electric potential of the negative electrode is attained by measuring in a charging process, thereby providing more accurate data support for judging whether lithium precipitation occurs in a lithium battery.

## BRIEF DESCRIPTION OF THE DRAWINGS

Accompanying drawings of the specification, which constitute a part of the present application, are used to provide a further understanding of the present invention, and the schematic examples of the present invention and descriptions thereof are used to explain the present invention, and do not constitute an improper limitation to the present invention. In the figures:

FIG. 1 shows a schematic diagram of a three-electrode cell structure in an implementation of the present invention.
FIG. 2 shows a schematic diagram of a three-electrode cell structure in another implementation of the present invention.
FIG. 3 shows a test diagram of an electric potential of a negative electrode of a three-electrode cell structure in Example 1 and Comparative Example 1 of the present invention.
FIG. 4 shows a photo of a negative electrode interface of battery disassembly after fully charging in Example 1 of the present invention.
FIG. 5 shows a photo of a negative electrode interface of battery disassembly after fully charging in Comparative Example 1 of the present invention.

The above accompanying drawings include the following reference numerals:
10, electrode group; 11, positive electrode; 12, negative electrode; 13, first separator membrane; 14, first reference electrode; 15, second separator membrane; 16, second reference electrode; 17, third separator membrane; and 18, fourth separator membrane.

## DETAILED DESCRIPTION

The present invention will be described in detail below with reference to the accompanying drawings and in combination with the examples.

As described in the background part, in the prior art, when a three-electrode method is used to test electric potential of a negative electrode, polarization is generated by the introduction of a separator membrane, resulting in inaccurate test results. In order to solve the problem, the present invention provides a three-electrode cell structure, including a shell, an electrolyte solution encapsulated inside the shell, and at least one electrode group, the electrode group includes a positive electrode 11, a negative electrode 12 and a first separator membrane 13 located between the positive electrode 11 and the negative electrode 12, and the at least one electrode group further includes a first reference electrode 14, located between the negative electrode 12 and the first separator membrane 13; a second separator membrane 15, located between the negative electrode 12 and the first reference electrode 14; a second reference electrode 16, located between the positive electrode 11 and the first separator membrane 13; and a third separator membrane 17, located between the positive electrode 11 and the second reference electrode 16. The first separator membrane 13, the second separator membrane 15 and the third separator membrane 17 all have the same structure.

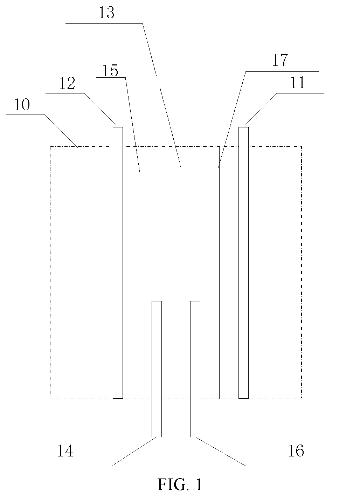

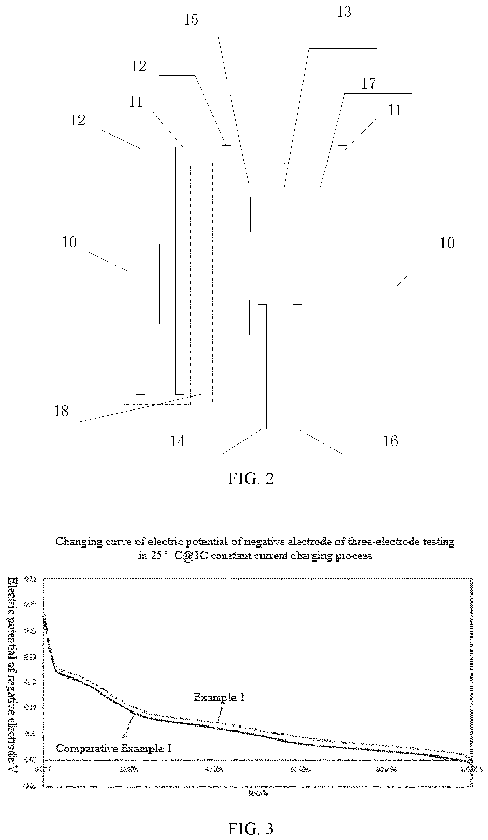

In the three-electrode cell structure of the present invention, in the at least one electrode group, the first separator membrane 13, the first reference electrode 14, the second separator membrane 15, the second reference electrode 16 and the third separator membrane 17 are sequentially disposed between the negative electrode 12 and the positive electrode 11 in a stacked mode. Different from a traditional three-electrode cell, the three-electrode cell structure of the present invention introduces the first reference electrode 14, the second separator membrane 15, the second reference electrode 16 and the third separator membrane 17 into the at least one electrode group. As shown in FIG. 1 and FIG. 2, the first reference electrode 14 is located between the negative electrode 12 and the first separator membrane 13, the second separator membrane 15 is located between the negative electrode 12 and the first reference electrode 14, the second reference electrode 16 is located between the positive electrode 11 and the first separator membrane 13, the third separator membrane 17 is located between the positive electrode 11 and the second reference electrode 16, and the first separator membrane 13, the second separator membrane 15 and the third separator membrane 17 all have the same structure.

In an actual measurement process, assembly is performed according to the three-electrode cell structure provided in the present invention in a production process of laminating and winding cells, then, a polarization difference value generated by the introduction of the separator membrane in testing the three electrodes can be corrected by testing a potential difference between the negative electrode and the first reference electrode 14, and a potential difference between the negative electrode and the second reference electrode 16, so that a deviation is effectively removed; and a more accurate electric potential of the negative electrode is attained by measuring in a charging process, thereby providing more accurate data support for judging whether lithium precipitation occurs in a battery. Specifically, in a subsequent testing process, the above three-electrode cell is charged, and in the charging process, an electric potential change of the first reference electrode 14 relative to the negative electrode is recorded as $\varphi 1$, an electric potential change of the second reference electrode 16 relative to the negative electrode is recorded as $\varphi 2$, a potential value of the negative electrode is designated as $\varphi_{negative\ electrode}$, and a polarization value caused by the separator membrane is designated as $\Delta\varphi_{separator\ membrane}$; and through the following calculation formulas: $\Delta\varphi_{separator\ membrane}=\varphi 2-\varphi 1$, and $\varphi_{negative\ electrode}=\varphi 1-\Delta\varphi_{separator\ membrane}$, the polarization value caused by the separator membrane $\Delta\varphi_{separator\ membrane}$ may be calculated, the deviation caused by the separator membrane is effectively removed, so as to obtain the more accurate electric potential of the negative electrode and provide more accurate data support for judging whether lithium precipitation occurs in the battery.

In the above three-electrode cell structure, in addition to the to-be-tested negative electrode, other separator membranes, positive electrodes and electrolyte solutions may all adopt commonly used types in the field of lithium batteries or a testing process of the three-electrode method. In a preferred embodiment, in the above three-electrode cell structure, the first separator membrane 13, the second separator membrane 15 and the third separator membrane 17 are each independently one of a porous polymer separator membrane, a non-woven fabric separator membrane or an inorganic composite separator membrane. The separator membranes may be purchased from separator membrane material companies such as Enjie, Xingyuan, Cangzhou Mingzhu and ZTE New Materials. The shell may be made of an aluminum plastic film, and may be a cylindrical or square shell specifically; and the electrolyte solution includes, but is not limited to one of organic solvent electrolyte lithium salts. In a preferred embodiment, the positive electrode 11 is made of lithium cobalt oxide LCO, a nickel-cobalt-manganese ternary material NCM or lithium iron phosphate LFP, and preferably, the positive electrode material has a length ranging from 5 cm to 30 cm, a width ranging from 3 cm to 20 cm, and a thickness ranging from 0.1 cm to 0.2 cm; and preferably, a negative electrode material is a carbon negative electrode material, a silicon negative electrode material or a lithium-containing transition metal nitride negative electrode material, and preferably, the negative electrode material has a length ranging from 5.5 cm to 30.5 cm, a width ranging from 3.5 cm to 20.5 cm, and a thickness ranging from 0.1 cm to 0.2 cm. The three-electrode cell structure may be obtained by encapsulating the above electrode group, shell and electrolyte solution according to a production process of a soft package cell or a square shell cell. These are all options that those skilled in the art can choose based on their own production needs, and will not be repeated here.

Preferably, the first reference electrode 14 and the second reference electrode 16 are both copper wires; preferably, each of the copper wires has a first end head and a second end head opposite to the first end head, wherein the first end head is a bare copper wire end head and located between the positive electrode 11 and the negative electrode 12; and the second end head is an enamelled copper wire end head and located outside the space between the positive electrode 11 and the negative electrode 12, and the second end head penetrates through the shell to extend to the outside of the shell. The copper wires are taken as the first reference electrode 14 and the second reference electrode 16, on the one hand, they are easy to obtain and have low costs. On the other hand, transmission efficiency of lithium ions between the positive electrode and the negative electrode may be improved, and potential of the positive electrode 11 and potential of the negative electrode 12 may be monitored in situ in a charging process of a lithium-ion battery. In addition, one ends of the reference electrodes are the copper wires, and the other ends of the reference electrodes are enamelled copper wires, in this way, interference of the electrolyte solution on electrical signals may be reduced to a larger extent, and thus detection accuracy is improved. Furthermore, it is inevitable that copper wires between the two end heads are immersed in the electrolyte solution in an encapsulation process, and in order to further reduce the interference of the electrolyte solution on the electrical signals, it is preferred to use the enamelled copper wires as copper wires in a middle section between the first end head and the second end head. In an actual assembly process, a whole copper wire may be used as the first reference electrode 14, another whole copper wire may be used as the second reference electrode 16, then first end heads of the copper wires are disposed as bare copper wire end heads, and the remaining parts, including the middle section and second end heads, are disposed as the enamelled copper wires.

EP 4 322 282 B1

In order to further improve stability of the setting of the first reference electrode 14 and the second reference electrode 16 and maintain the stability of currents in the electrode group, so as to further improve the detection accuracy, preferably, the first end head has a length ranging from 1 cm to 2.5 cm; and preferably, the enamelled copper wire end head has a diameter ranging from 22 $\mu$m to 53 $\mu$m, and the bare copper wire end head has a diameter ranging from 20 $\mu$m to 50 $\mu$m.

Preferably, a metal lithium layer is plated on a surface of the first end head. In this way, the potential stability of the reference electrodes may be further improved, thereby promoting the detection accuracy to be higher.

For the three-electrode cell structure on the one hand, capacity demands of a conventional battery may be met, and on the other hand, the electric potential of the negative electrode in a charging and discharging process of the battery itself may further be tested. Preferably, in an embodiment, conventional battery production is simulated, when the three-electrode cell structure includes a plurality of electrode groups, as shown in FIG. 2, the plurality of electrode groups 10 are sequentially disposed in parallel, every two adjacent electrode groups 10 are separated through a fourth separator membrane 18, and the fourth separator membrane 18 has the same structure as the first separator membrane 13. This may be operated according to the well-known battery preparation process in the art, which may be self-assembled by those skilled in the art according to production needs. For example, parallel setting refers to the negative electrode 12 of the second electrode group being close to the positive electrode 11 of the first electrode group, and the two are separated by the fourth separator membrane 18, which will not be repeated here.

The application provides a preparation method for the above three-electrode cell structure. The preparation method includes the following steps: step S1, at least one electrode group is provided, wherein each electrode group includes a positive electrode 11, a negative electrode 12 and a first separator membrane 13 located between the positive electrode 11 and the negative electrode 12, and the at least one electrode group further includes: a first reference electrode 14 disposed between the negative electrode 12 and the first separator membrane 13; a second separator membrane 15 disposed between the negative electrode 12 and the first reference electrode 14; a second reference electrode 16 disposed between the positive electrode 11 and the first separator membrane 13; and a third separator membrane 17 disposed between the positive electrode 11 and the second reference electrode 16, wherein the first separator membrane 13, the second separator membrane 15 and the third separator membrane 17 all have the same structure; and step S2, the at least one electrode group is encapsulated in a shell, and the shell is filled with an electrolyte solution to obtain the three-electrode cell structure.

Based on the various reasons mentioned earlier, the three-electrode cell structure of the present disclosure introduces the first reference electrode 14, the second separator membrane 15, the second reference electrode 16 and the third separator membrane 17 into the at least one electrode group. The first reference electrode 14 is located between the negative electrode 12 and the first separator membrane 13, the second separator membrane 15 is located between the negative electrode 12 and the first reference electrode 14, the second reference electrode 16 is located between the positive electrode 11 and the first separator membrane 13, the third separator membrane 17 is located between the positive electrode 11 and the second reference electrode 16, and the first separator membrane 13, the second separator membrane 15 and the third separator membrane 17 all have the same structure. Specifically, in a cell production and manufacturing process, assembly is performed according to the three-electrode cell structure then, a polarization difference value generated by the introduction of the separator membrane in testing the three electrodes can be corrected by testing a potential difference between the negative electrode and the first reference electrode 14, and a potential difference between the negative electrode and the second reference electrode 16, so that a deviation is effectively removed; and a more accurate electric potential of the negative electrode is attained by measuring in a charging process, thereby providing more accurate data support for judging whether lithium precipitation occurs in a battery. Specifically, in a subsequent testing process, the above three-electrode cell is charged, in a charging process, an electric potential change of the first reference electrode 14 relative to the negative electrode is recorded as $\varphi 1$, an electric potential change of the second reference electrode 16 relative to the negative electrode is recorded as $\varphi 2$, a potential value of the negative electrode is designated as $\varphi_{negative\ electrode}$, and a polarization value caused by the separator membrane is designated as $\Delta\varphi_{separator\ membrane}$; and through the following calculation formulas: $\Delta\varphi_{separator\ membrane}=\varphi 2-\varphi 1$, and $\varphi_{negative\ electrode}=\varphi 1-\Delta\varphi_{separator}$ membrane, the polarization value caused by the separator membrane $\Delta\varphi_{separator\ membrane}$ may be calculated, the deviation caused by the separator membrane is effectively removed, so as to obtain the more accurate electric potential of the negative electrode and provide more accurate data support for judging whether lithium precipitation occurs in the battery.

Preferably, in step S1, a process of disposing the first reference electrode 14 and the second reference electrode 16 is as follows: one end of an enamelled copper wire is put into concentrated sulfuric acid with a concentration of 98% to remove an enamelled coating on a surface thereof, then it is washed with water to obtain a copper wire with a first end head as a bare copper wire end head and a second end head as an enamelled copper wire end head; the first end head of one copper wire is put between the negative electrode 12 and the first separator membrane 13, and the second end head is put outside the negative electrode 12 and the first separator membrane 13; the first end head of the other copper wire is put between the positive electrode 11 and the first separator membrane 13, and the second end head is put outside the space between the positive electrode 11 and the first separator membrane 13; and after the encapsulation step, the first reference electrode 14 and the second reference electrode 16 are formed. In this way, the outer enamelled part of the first end head may be completely removed to obtain a bare copper wire with a higher purity, thereby improving the transmission efficiency of the lithium ions between the positive electrode and the negative electrode. Preferably, washing treatment may further remove the residual concentrated sulfuric acid on the surface of the bare copper wire at the first end head.

Preferably, after the step of filling the shell with the electrolyte solution, the step S2 further includes a step of plating lithium on a surface of the bare copper wire end head; preferably, lithium plating treatment is performed on the first reference electrode 14 and the second reference electrode 16 respectively by using a current ranging from 10 mA to 15 mA; and preferably, a lithium plating treatment process is performed for treatment time ranging from 6h to 8h. In this way, the lithium plating process is more stable, the effects of detecting internal chemical and electrochemical reactions in the battery may be further balanced, and thus the detection accuracy is improved. In an actual operation process, an external power supply is provided, firstly, a positive electrode of the power supply is connected with the positive electrode 11 in the three-electrode cell structure of the present invention, a negative electrode of the power supply is connected with the reference electrodes in the three-electrode cell structure of the present invention, after treating with the current ranging from 10 mA to 15 mA for 3h, the positive electrode of the power supply is connected with the negative electrode in the three-electrode cell structure of the present invention, the negative electrode of the power supply is connected with the reference electrodes in the three-electrode cell structure and similarly after treating with the current ranging from 10 mA to 15 mA for 3h, the reference electrodes with metal lithium layers plated on the surfaces of the first end heads are obtained. This is an operation that may be performed by those skilled in the art in conjunction with conventional knowledge, which will not be repeated here.

The present invention further provides a method for testing an electric potential of a negative electrode according to claim 1, including the following steps: a three-electrode cell is provided, the three-electrode cell being the above three-electrode cell or a three-electrode cell prepared by the above preparation method, wherein a negative electrode in the three-electrode cell is a to-be-tested negative electrode 12; the three-electrode cell is charged, in a charging process, an electric potential change of a first reference electrode 14 relative to the negative electrode 12 is recorded as $\varphi1$, an electric potential change of a second reference electrode 16 relative to the negative electrode 12 is recorded as $\varphi2$, a potential value of the negative electrode 12 is designated as $\varphi_{negative\ electrode}$, and a polarization value caused by a separator membrane is designated as $\Delta\varphi_{separator\ membrane}$; and the potential on the surface of the negative electrode 12 is calculated, wherein calculation formulas are as follows: $\Delta\varphi_{separator\ membrane}=\varphi2-\varphi1$, and $\varphi_{negative\ electrode}=\varphi1 - \Delta\varphi_{separator\ membrane}$.

Based on the various reasons mentioned earlier, in an actual measurement process, assembly is performed according to the three-electrode cell structure provided in the present invention, then, a polarization difference value generated by the introduction of the separator membrane in testing the three electrodes can be corrected by testing a potential difference between the negative electrode and the first reference electrode 14, and a potential difference between the negative electrode and the second reference electrode 16, so that a deviation is effectively removed; and a more accurate electric potential of the negative electrode is attained by measuring in a charging process, thereby providing more accurate data support for judging whether lithium precipitation occurs in a battery. Specifically, in a subsequent testing process, the above three-electrode cell is charged, in a charging process, an electric potential change of the first reference electrode 14 relative to the negative electrode is recorded as $\varphi1$, an electric potential change of the second reference electrode 16 relative to the negative electrode is recorded as $\varphi2$, a potential value of the negative electrode is designated as $\varphi_{negative\ electrode}$, and a polarization value caused by the separator membrane is designated as $\Delta\varphi_{separator\ membrane}$; and through the following calculation formulas: $\Delta\varphi_{separator\ membrane}=\varphi2-\varphi1$, and $\varphi_{negative\ electrode}=\varphi1-\Delta\varphi_{separator\ membrane}$, the polarization value $\Delta\varphi_{separator\ membrane}$ caused by the separator membrane separator membrane may be calculated, the deviation caused by the separator membrane is effectively removed, so as to obtain the more accurate electric potential of the negative electrode and provide more accurate data support for judging whether lithium precipitation occurs in the battery.

In order to further promote the stability of the charging process to be better, so as to improve the detection accuracy, preferably, the charging process is performed at a temperature ranging from -45°C to 60°C.

The present application is further described in details in conjunction with specific examples below, and these examples cannot be understood as limiting the scope of protection claimed in the present application.

Example 1

Negative electrode sheet source: 5 Ah soft package cell graphite negative electrode. A negative electrode material is Gr graphite, with a length of 105 mm, a width of 55 mm and a thickness of 0.1 mm.

Positive electrode sheet source: 5 Ah soft package cell NCM ternary positive electrode. A positive electrode material is an NCM ternary positive electrode, with a length of 100 mm, a width of 50 mm and a thickness of 0.1 mm.

A separator membrane is purchased from a porous polymer separator membrane of ZTE New Materials Technology Co., Ltd.

A three-electrode cell structure is as shown in FIG. 1, and a process for preparing the three-electrode cell structure is as follows.

1. One ends of 2 cm with a diameter of 20 mm of two enamelled copper wires are put into concentrated sulfuric acid respectively to remove enamelled coatings on surfaces, and then they are washed with water to obtain two copper wires with first end heads as bare copper wire end heads and second end heads as enamelled copper wire end heads, which are a first reference electrode and a second reference electrode respectively.

2. A second separator membrane, the first reference electrode, a first separator membrane, the second reference electrode, a third separator membrane and a positive electrode sheet are sequentially disposed on a negative electrode sheet to obtain an electrode group, wherein the first end head of the first reference electrode is put between the negative electrode and the first separator membrane, and the second end head is put outside the negative electrode and the first separator membrane; and the first end head of the second reference electrode is put between the positive electrode and the first separator membrane, and the second end head is put outside the space between the positive electrode and the first separator membrane.

3. Parts of the second end heads of the first reference electrode and the second reference electrode are guided out of a cell shell, and a nickel belt is welded to the second end heads.

4. The above electrode group, shell and an electrode solution are encapsulated according to a production process of a soft package cell or a square shell cell.

5. After encapsulation, lithium plating is performed on the first reference electrode and the second reference electrode respectively by using a current of 10 mA, and metal lithium layers are both formed at the first end heads of the two to obtain the three-electrode cell structure.

6. The above three-electrode cell structure is charged at a 1C rate at a temperature ranging from -40°C to -30°C, and meanwhile electric potential changes of the first reference electrode and the second reference electrode relative to the negative electrode are monitored.

7. In a charging process, the electric potential change of the first reference electrode relative to the negative electrode is recorded as $\varphi1$, the electric potential change of the second reference electrode relative to the negative electrode 12 is recorded as $\varphi2$, a potential value of the negative electrode is designated as $\varphi_{negative\ electrode}$, and a polarization value caused by the separator membrane is designated as $\Delta\varphi_{separator\ membrane}$; and potential on the surface of the negative electrode is calculated through $\Delta\varphi_{separator\ membrane}=\varphi2-\varphi1$ and $\varphi_{negative\ electrode}=\varphi1-\Delta\varphi_{separator\ membrane}$.

Example 2

The difference from Example 1 is only that the three-electrode cell structure includes two electrode groups, and the three-electrode cell structure is as shown in FIG. 2.

Comparative Example 1

The difference from Example 1 is only that there is no second separator membrane and second reference electrode. The electric potential change of the first reference electrode relative to the negative electrode is the potential on the surface of the negative electrode.

Performance representation:

The cells in Example 1 and Comparative Example 1 are put into a constant temperature and humidity box (Sanmu Technology brand, with a temperature control range from -70°C to 180°C, and a humidity range from 10% to 98%), and the cells are subject to charging and discharging cycling through a 5 V, 6 A Xinwei charging and discharging device. Charging is performed at a constant current of 1 C to a charge cutoff voltage and then performed at a constant voltage, charging is stopped until a charge end current drops to 0.05 C, it is subject to standing for 0.5h after charging, and then discharging is performed at 1 C to a discharge end voltage. This system is performed for 2000 cycles until a discharge capacity is 80% of an initial capacity, and after cycling, the cells are charged fully (soc100%).

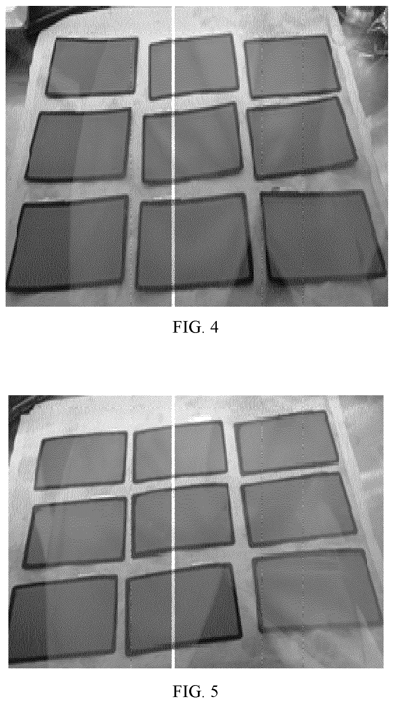

The fully charged cells are disassembled, their negative electrode interfaces are observed, no lithium precipitation is observed on surfaces of negative electrode sheets tested in Examples and Comparative Example, that is, lithium precipitation does not occur in the tested cells in Example 1 and Comparative Example 1 under an environmental temperature of 25°C and 1 C cycling conditions, as shown in FIG. 4 (Example 1) and FIG. 5 (Comparative Example 1). As shown in FIG. 3, in Example 1, the corrected potential on the surface of the negative electrode after charging 100% is a positive value, indicating that test results in Example 1 of the present invention are consistent with actual situations. But in Comparative Example 1, the potential on the surface of the negative electrode after charging 100% is a negative value, which is not consistent with the actual situations. Whether lithium precipitation occurs is judged through a three-electrode cell, with the electric potential of the negative electrode of 0 V as a standard. When the electric potential of the negative electrode is less than 0 V, it is considered that lithium precipitation occurs. However, in an actual production process of the three-electrode cell, it is necessary to add a separator membrane outside a reference electrode, the separator membrane is introduced into the production process to generate polarization, which will cause a certain deviation in test results of three electrodes. The polarization value caused by the separator membrane cannot be tested in Comparative Example 1, so its test results are inaccurate. In the present invention, the polarization value caused by the separator membrane may be tested, so that an actual potential value on the surface of the negative electrode may be obtained by correcting, and the test results are more accurate.

FIG. 3 shows change curves of electric potentials of negative electrodes of three-electrode cell structures in Example 1 and Comparative Example 1 of the present invention during charging at a constant current of 1 C at 25°C. An abscissa is a battery charging state (soc/%), which is 0.00%, 20.00%, 40.00%, 60.00%, 80.00% and 100.00% sequentially, and an ordinate is an electric potential of the negative electrode (V), which is -0.05, 0.00, 0.05, 0.10, 0.15, 0.20, 0.25, 0.30 and 0.35 sequentially.

**Claims**

1.  A method for testing an electric potential of a negative electrode, comprising:

    providing a three-electrode cell, wherein the three-electrode cell comprises a shell, an electrolyte solution encapsulated inside the shell, and at least one electrode group (10),
    wherein the electrode group comprises a positive electrode (11), a negative electrode (12) and a first separator membrane (13) located between the positive electrode (11) and the negative electrode (12), wherein the negative electrode (12) is a to-be-tested negative electrode, and the at least one electrode group further comprises:

    a first reference electrode (14) disposed between the negative electrode (12) and the first separator membrane (13);
    a second separator membrane (15) disposed between the negative electrode (12) and the first reference electrode (14);
    a second reference electrode (16) disposed between the positive electrode (11) and the first separator membrane (13); and
    a third separator membrane (17) disposed between the positive electrode (11) and the second reference electrode (16);
    wherein, the first separator membrane (13), the second separator membrane (15) and the third separator membrane (17) all have the same structure;
    charging the three-electrode cell, and in the charging process, recording an electric potential change of the first reference electrode (14) relative to the negative electrode (12) as $\varphi1$, recording an electric potential change of the second reference electrode (16) relative to the negative electrode (12) as $\varphi2$;

    **characterized in that**, the method further comprises the following steps:
    designating an electric potential value of the negative electrode as $\varphi_{negative\ electrode}$, and designating a polarization value caused by a separator membrane as $\Delta\varphi_{separator\ membrane}$; and calculating the electric potential value of the negative electrode by using the following formula I and formula II:

    $$\Delta\varphi_{separator\ membrane}=\varphi2-\varphi1 \qquad \text{which is the formula I;}$$

    $$\varphi_{negative\ electrode}=\varphi1-\Delta\varphi_{separator\ membrane} \qquad \text{which is the formula II.}$$

2.  The method of claim 1, **characterized in that**, the first reference electrode (14) and the second reference electrode (16) are both copper wires.

3.  The method of claim 2, **characterized in that**, each of the copper wires has a first end head and a second end head opposite to the first end head, wherein the first end head is a bare copper wire end head and located between the positive electrode (11) and the negative electrode (12); and the second end head is an enamelled copper wire end head and located outside the space between the positive electrode (11) and the negative electrode (12), and the second end head penetrates through the shell to extend to the outside of the shell, and the first end head has a length ranging from 1 cm to 2.5 cm.

4. The method of claim 3, **characterized in that** a metal lithium layer is plated on a surface of the first end head.

5. The method of any one of claims 1 to 3, **characterized in that**, when the three-electrode cell comprises a plurality of electrode groups, the plurality of electrode groups are sequentially connected in parallel, every two adjacent electrode groups are separated by a fourth separator membrane (18), and the fourth separator membrane (18) has the same structure as the first separator membrane (13).

6. The method of claim 1, **characterized in that**, the process of disposing the first reference electrode (14) and the second reference electrode (16) is as follows:

putting one end of an enamelled copper wire into concentrated sulfuric acid with a mass concentration of 98% to remove an enamelled coating on a surface thereof, then washing with water to obtain a copper wire with a first end head as a bare copper wire end head and a second end head as an enamelled copper wire end head; putting the first end head of one copper wire prepared by the above step between the negative electrode (12) and the first separator membrane (13), and putting the second end head thereof outside the space between the negative electrode (12) and the first separator membrane (13) to form the first reference electrode (14); putting the first end head of another copper wire prepared by the above step between the positive electrode (11) and the first separator membrane (13), and putting the second end head thereof outside the space between the positive electrode (11) and the first separator membrane (13) to form the second reference electrode (16); and arranging, after encapsulation, the second end heads of the first reference electrode (14) and the second reference electrode (16) to both penetrate through the shell to extend to the outside of the shell.

7. The method of claim 6, **characterized in that**, the three-electrode cell is obtained by encapsulating the at least one electrode group by the shell, and filling the shell with the electrolyte solution, wherein, after the step of filling the shell with the electrolyte solution, the method further comprises a step of performing lithium plating on a surface of the bare copper wire end head.

8. The method of claim 1 for testing an electric potential of a negative electrode, **characterized in that** the charging process is performed at a temperature ranging from -45°C to 60°C.


**Patentansprüche**

1. Verfahren zum Testen eines elektrischen Potenzials einer Negativelektrode, umfassend:
Bereitstellen einer Dreielektroden-Zelle, wobei die Dreielektroden-Zelle eine Hülle, eine innerhalb der Hülle eingekapselte Elektrolytlösung und mindestens eine Elektrodengruppe (10) umfasst, wobei die Elektrodengruppe eine Positivelektrode (11), eine Negativelektrode (12) und eine erste Separatormembran (13) umfasst, die sich zwischen der Positivelektrode (11) und der Negativelektrode (12) befindet, wobei die Negativelektrode (12) eine zu testende Negativelektrode ist und die mindestens eine Elektrodengruppe ferner Folgendes umfasst:

eine erste Referenzelektrode (14), die zwischen der Negativelektrode (12) und der ersten Separatormembran (13) angeordnet ist;
eine zweite Separatormembran (15), die zwischen der Negativelektrode (12) und der ersten Referenzelektrode (14) angeordnet ist;
eine zweite Referenzelektrode (16), die zwischen der Positivelektrode (11) und der ersten Separatormembran (13) angeordnet ist; und
eine dritte Separatormembran (17), die zwischen der Positivelektrode (11) und der zweiten Referenzelektrode (16) angeordnet ist;
wobei die erste Separatormembran (13), die zweite Separatormembran (15) und die dritte Separatormembran (17) alle dieselbe Struktur aufweisen;
Laden der Dreielektroden-Zelle und beim Ladevorgang Aufzeichnen einer elektrischen Potenzialänderung der ersten Referenzelektrode (14) relativ zu der Negativelektrode (12) als $\varphi1$, Aufzeichnen einer elektrischen Potenzialänderung der zweiten Referenzelektrode (16) relativ zu der Negativelektrode (12) als $\varphi2$;
**dadurch gekennzeichnet, dass** das Verfahren ferner den folgenden Schritt umfasst:
Benennen eines elektrischen Potenzialwerts der Negativelektrode als $\varphi_{Negativelektrode}$ und Benennen eines durch eine Separatormembran verursachten Polarisationswerts als $\Delta\varphi_{Separatormembran}$; und Berechnen des elektrischen Potenzialwerts der Negativelektrode unter Verwendung der folgenden Formel I und Formel II:

$$\Delta\varphi_{Separatormembran} = \varphi2 - \varphi1 \qquad \text{was der Formel I entspricht;}$$

$$\varphi_{Negativelektrode} = \varphi1 - \Delta\varphi_{Separatormembran} \qquad \text{was der Formel II entspricht.}$$

2. Verfahren nach Anspruch 1, **dadurch gekennzeichnet, dass** die erste Referenzelektrode (14) und die zweite Referenzelektrode (16) beide Kupferdrähte sind.

3. Verfahren nach Anspruch 2, **dadurch gekennzeichnet, dass** jeder der Kupferdrähte eine erste Kopfseite und eine zweite Kopfseite gegenüber der ersten Kopfseite aufweist, wobei die erste Kopfseite eine blanke Kupferdraht-Kopfseite ist und zwischen der Positivelektrode (11) und der Negativelektrode (12) angeordnet ist; und die zweite Kopfseite eine emaillierte Kupferdraht-Kopfseite ist und außerhalb des Raums zwischen der Positivelektrode (11) und der Negativelektrode (12) angeordnet ist und die zweite Kopfseite durch die Hülle hindurchdringt, um sich zur Außenseite der Hülle zu erstrecken, und die erste Kopfseite eine Länge im Bereich von 1 cm bis 2,5 cm aufweist.

4. Verfahren nach Anspruch 3, **dadurch gekennzeichnet, dass** eine Metall-Lithium-Schicht auf eine Oberfläche der ersten Kopfseite plattiert ist.

5. Verfahren nach einem der Ansprüche 1 bis 3, **dadurch gekennzeichnet, dass**, wenn die Dreielektroden-Zelle eine Vielzahl von Elektrodengruppen umfasst, die Vielzahl von Elektrodengruppen nacheinander parallelgeschaltet sind, jeweils zwei benachbarte Elektrodengruppen durch eine vierte Separatormembran (18) getrennt sind und die vierte Separatormembran (18) dieselbe Struktur wie die erste Separatormembran (13) aufweist.

6. Verfahren nach Anspruch 1, **dadurch gekennzeichnet, dass** der Prozess des Anordnens der ersten Referenzelektrode (14) und der zweiten Referenzelektrode (16) wie folgt erfolgt:

Einlegen eines Endes eines emaillierten Kupferdrahts in konzentrierte Schwefelsäure mit einer Massenkonzentration von 98 %, um eine emaillierte Beschichtung auf einer Oberfläche davon zu entfernen, dann Waschen mit Wasser, um einen Kupferdraht mit einer ersten Kopfseite als blanke Kupferdraht-Kopfseite und eine zweite Kopfseite als emaillierte Kupferdraht-Kopfseite zu erhalten;
Anbringen der ersten Kopfseite eines durch den obigen Schritt aufbereiteten Kupferdrahts zwischen der Negativelektrode (12) und der ersten Separatormembran (13) und Anbringen der zweiten Kopfseite davon außerhalb des Raums zwischen der Negativelektrode (12) und der ersten Separatormembran (13), um die erste Referenzelektrode (14) zu bilden;
Anbringen der ersten Kopfseite eines anderen durch den obigen Schritt aufbereiteten Kupferdrahts zwischen der Positivelektrode (11) und der ersten Separatormembran (13) und Anbringen der zweiten Kopfseite davon außerhalb des Raums zwischen der Positivelektrode (11) und der ersten Separatormembran (13), um die zweite Referenzelektrode (16) zu bilden; und
Anordnen, nach dem Verkapseln, der zweiten Kopfseite der ersten Referenzelektrode (14) und der zweiten Referenzelektrode (16), sodass beide durch die Hülle dringen, um sich zu der Außenseite der Hülle zu erstrecken.

7. Verfahren nach Anspruch 6, **dadurch gekennzeichnet, dass** die Dreielektroden-Zelle erhalten wird, indem die mindestens eine Elektrodengruppe durch die Hülle eingekapselt wird und die Hülle mit der Elektrolytlösung gefüllt wird, wobei das Verfahren nach dem Schritt des Füllens der Hülle mit der Elektrolytlösung ferner einen Schritt des Durchführens einer Lithiumplattierung auf einer Oberfläche der blanken Kupferdraht-Kopfseite umfasst.

8. Verfahren nach Anspruch 1 zum Testen eines elektrischen Potenzials einer Negativelektrode, **dadurch gekennzeichnet, dass** der Ladevorgang bei einer Temperatur im Bereich von -45 °C bis 60 °C durchgeführt wird.

**Revendications**

1. Procédé de test d'un potentiel électrique d'une électrode négative, comprenant :
la fourniture d'une cellule à trois électrodes, ladite cellule à trois électrodes comprenant une enveloppe, une solution d'électrolyte encapsulée à l'intérieur de l'enveloppe, et au moins un groupe d'électrodes (10), ledit groupe d'électrodes comprenant une électrode positive (11), une électrode négative (12) et une première membrane séparatrice (13) située entre l'électrode positive (11) et l'électrode négative (12), ladite électrode négative (12) étant une électrode négative à tester, et ledit au moins un groupe d'électrodes comprenant en outre :

une première électrode de référence (14) disposée entre l'électrode négative (12) et la première membrane séparatrice (13) ;

une deuxième membrane séparatrice (15) disposée entre l'électrode négative (12) et la première électrode de référence (14) ;

une seconde électrode de référence (16) disposée entre l'électrode positive (11) et la première membrane séparatrice (13) ; et

une troisième membrane séparatrice (17) disposée entre l'électrode positive (11) et la seconde électrode de référence (16) ;

ladite première membrane séparatrice (13), ladite deuxième membrane séparatrice (15) et la troisième membrane séparatrice (17) possédant toutes la même structure ;

la charge de la cellule à trois électrodes, et dans le processus de charge, l'enregistrement d'un changement de potentiel électrique de la première électrode de référence (14) par rapport à l'électrode négative (12) en tant que $\varphi 1$, l'enregistrement d'un changement de potentiel électrique de la seconde électrode de référence (16) par rapport à l'électrode négative (12) en tant que $\varphi 2$ ;

**caractérisé en ce que** le procédé comprend en outre les étapes suivantes :

la désignation d'une valeur de potentiel électrique de l'électrode négative comme $\varphi_{\text{électrode négative}}$, et la désignation d'une valeur de polarisation entraînée par une membrane séparatrice en tant que $\Delta\varphi_{\text{membrane séparatrice}}$, et le calcul de la valeur de potentiel électrique de l'électrode négative à l'aide des formules I et II suivantes :

$$\Delta\varphi_{\text{membrane séparatrice}} = \varphi 2 - \varphi 1 \qquad \text{qui est la formule I ;}$$

$$\varphi_{\text{électrode négative}} = \varphi 1 - \Delta\varphi_{\text{membrane séparatrice}} \qquad \text{qui est la formule II.}$$

2. Procédé de la revendication 1, **caractérisé en ce que** la première électrode de référence (14) et la seconde électrode de référence (16) sont toutes deux des fils de cuivre.

3. Procédé de la revendication 2, **caractérisé en ce que** chacun des fils de cuivre possède une première tête d'extrémité et une seconde tête d'extrémité opposée à la première tête d'extrémité, ladite première tête d'extrémité étant une tête d'extrémité de fil de cuivre nu et située entre l'électrode positive (11) et l'électrode négative (12) ; et ladite seconde tête d'extrémité étant une tête d'extrémité de fil de cuivre émaillé et située à l'extérieur de l'espace entre l'électrode positive (11) et l'électrode négative (12), et ladite seconde tête d'extrémité pénétrant à travers l'enveloppe pour s'étendre à l'extérieur de l'enveloppe, et ladite première tête d'extrémité possédant une longueur allant de 1 cm à 2,5 cm.

4. Procédé de la revendication 3, **caractérisé en ce qu'**une couche de lithium métallique est plaquée sur une surface de la première tête d'extrémité.

5. Procédé de l'une quelconque des revendications 1 à 3, **caractérisé en ce que**, lorsque la cellule à trois électrodes comprend une pluralité de groupes d'électrodes, la pluralité de groupes d'électrodes sont connectés séquentiellement en parallèle, tous les deux groupes d'électrodes adjacents sont séparés par une quatrième membrane séparatrice (18), et la quatrième membrane séparatrice (18) possède la même structure que la première membrane séparatrice (13).

6. Procédé de la revendication 1, **caractérisé en ce que** le processus de disposition de la première électrode de référence (14) et de la seconde électrode de référence (16) est le suivant :

mise en place d'une extrémité d'un fil de cuivre émaillé dans de l'acide sulfurique concentré possédant une concentration massique de 98 % pour enlever un revêtement émaillé sur une surface de celui-ci, puis lavage à l'eau pour obtenir un fil de cuivre avec une première tête d'extrémité sous la forme d'une tête d'extrémité de fil de cuivre nu et une seconde tête d'extrémité sous la forme d'une tête d'extrémité de fil de cuivre émaillé ;

mise en place de la première tête d'extrémité d'un fil de cuivre préparé par l'étape ci-dessus entre l'électrode négative (12) et de la première membrane séparatrice (13), et mise en place de la seconde tête d'extrémité de celle-ci à l'extérieur de l'espace entre l'électrode négative (12) et la première membrane séparatrice (13) pour former la première électrode de référence (14) ;

mise en place de la première tête d'extrémité d'un autre fil de cuivre préparé par l'étape ci-dessus entre l'électrode positive (11) et la première membrane séparatrice (13), et mise en place de la seconde tête d'extrémité de celle-ci à l'extérieur de l'espace entre l'électrode positive (11) et la première membrane séparatrice (13) pour former la seconde électrode de référence (16) ;

agencement, après encapsulation, des secondes têtes d'extrémité de la première électrode de référence (14) et de la seconde électrode de référence (16) pour qu'elles pénètrent toutes deux à travers l'enveloppe pour s'étendre vers l'extérieur de l'enveloppe.

7. Procédé de la revendication 6, **caractérisé en ce que** la cellule à trois électrodes est obtenue par l'encapsulation de l'au moins un groupe d'électrodes par l'enveloppe, et le remplissage de l'enveloppe avec la solution d'électrolyte, après l'étape de remplissage de l'enveloppe avec la solution d'électrolyte, ledit procédé comprenant en outre une étape de réalisation d'un placage au lithium sur une surface de la tête d'extrémité de fil de cuivre nu.

8. Procédé de la revendication 1 pour tester un potentiel électrique d'une électrode négative, **caractérisé en ce que** le processus de charge est effectué à une température comprise entre -45°C et 60°C.

FIG. 1

FIG. 2

Changing curve of electric potential of negative electrode of three-electrode testing in 25° C@1C constant current charging process

FIG. 3

FIG. 4

FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2017156757 A

- CN 110797569 A